## Europäisches Patentamt

## European Patent Office

## Office européen des brevets

(19)

(11) Veröffentlichungsnummer: **0 098 497**
A2

(12) **EUROPÄISCHE PATENTANMELDUNG**

(21) Anmeldenummer: 83106249.2

(22) Anmeldetag: 27.06.83

(51) Int. Cl.³: **H 01 L 29/78**, H 01 L 29/10

(30) Priorität: 01.07.82 DE 3224618

(43) Veröffentlichungstag der Anmeldung: 18.01.84
Patentblatt 84/3

(84) Benannte Vertragsstaaten: **CH DE FR GB IT LI**

(71) Anmelder: **SIEMENS AKTIENGESELLSCHAFT, Berlin
und München Wittelsbacherplatz 2,
D-8000 München 2 (DE)**

(72) Erfinder: **Tihanyi, Jenö, Dr. Ing., Wolfratshauser
Strasse 179 b, D-8000 München 71 (DE)**

(54) **IGFET mit Ladungsträgerinjektion.**

(57) Der Durchlaßwiderstand von Leistungs-MOSFET kann durch in die Drainzone (2) injizierte Ladungsträger herabgesetzt werden, die aus einer externen Quelle (+$U_i$) stammen. Dazu ist eine unter der Gateelektrode (12) liegende Injektorzone (8) vorgesehen. Deren Dotierung ist so eingestellt, daß sich bei einer den FET einschaltenden Gatespannung an ihrer Oberfläche eine Inversionsschicht (13) ausbildet, die als Emitter wirkt. Die Inversionsschicht bildet mit der Injektorzone und der Drainzone einen Bipolartransistor, der den Durchlaßwiderstand durch Ladungsträgerinjektion herabsetzt.

SIEMENS AKTIENGESELLSCHAFT          Unser Zeichen
Berlin und München                  VPA       82 P 1511 E

IGFET mit Ladungsträgerinjektion

Die Erfindung bezieht sich auf einen IGFET mit einem
Halbleitersubstrat vom ersten Leitungstyp, mit mindestens
einer in die erste Oberfläche des Substrats eingebetteten
Kanalzone vom entgegengesetzten Leitungstyp und mit einer
in die Kanalzone eingebetteten Sourcezone vom ersten Leitungstyp, mit einer an die erste Oberfläche angrenzenden
Drainzone, mit einer mit der anderen Oberfläche verbundenen Drainelektrode, mit einer in die erste Oberfläche
eingebetteten, an eine Spannung anschließbaren Injektorzone vom entgegengesetzten Leitungstyp, und mit einer gegen die erste Oberfläche isolierten Gateelektrode.

Ein solcher IGFET ist Gegenstand der älteren deutschen
Patentanmeldung P 31 03 444.6. Die Injektorzone hat den
Zweck, den insbesondere bei Hochvolt-Leistungs-FET relativ hohen Durchlaßwiderstand zu verringern. Die Injektorzone ist dazu an eine externe Spannungsquelle angeschlossen und injiziert dann Ladungsträger in die Drainzone
des IGFET, wenn der der Injektorzone benachbarte, an der
Oberfläche liegende Bereich der Drainzone durch eine sich
unter der Gateelektrode ausbildende Akkumulationsschicht
gegenüber dem Drainpotential negativ wird. Die die Drainzone injizierten Ladungsträger bewirken quasi eine Erhöhung der Dotierung im Stromweg. Dies kommt einer Verringerung des Durchlaßwiderstands $R_{on}$ gleich.

Die Erfindung bezweckt ausgehend von der geschilderten
Anordnung eine weitere Reduzierung des Durchlaßwiderstands $R_{on}$.

Hab 1 Dx / 30.06.1982

0098497

Die Erfindung ist dadurch gekennzeichnet, daß die Injektorzone unter der Gateelektrode liegt, daß die Dotierung der Injektorzone zumindest an der Oberfläche derart bemessen ist, daß sich bei eingeschaltetem IGFET an der Oberfläche der Injektorzone eine Inversionsschicht ausbildet, daß die Injektorzone über eine in die erste Oberfläche eingebettete Kontaktzone vom gleichen Leitungstyp wie die Injektorzone kontaktiert ist, daß die Dotierung der Kontaktzone höher als die der Injektorzone und derart bemessen ist, daß sich bei eingeschaltetem IGFET an der Oberfläche der Kontaktzone keine Inversionsschicht ausbildet, und daß die Gateelektrode über der Grenze Kontaktzone-Injektorzone liegt.

Weiterbildungen sind Gegenstand der Unteransprüche.

Die Erfindung wird an Hand zweier Ausführungsbeispiele in Verbindung mit den Fig. 1 bis 3 näher erläutert. Es zeigen:

Fig. 1 einen Schnitt durch ein erstes Ausführungsbeispiel,

Fig. 2 einen Schnitt durch ein zweites Ausführungsbeispiel und

Fig. 3 die Aufsicht auf eine Halbleiteranordnung mit einer Vielzahl von auf einem Chip integrierten IGFET nach Fig. 2.

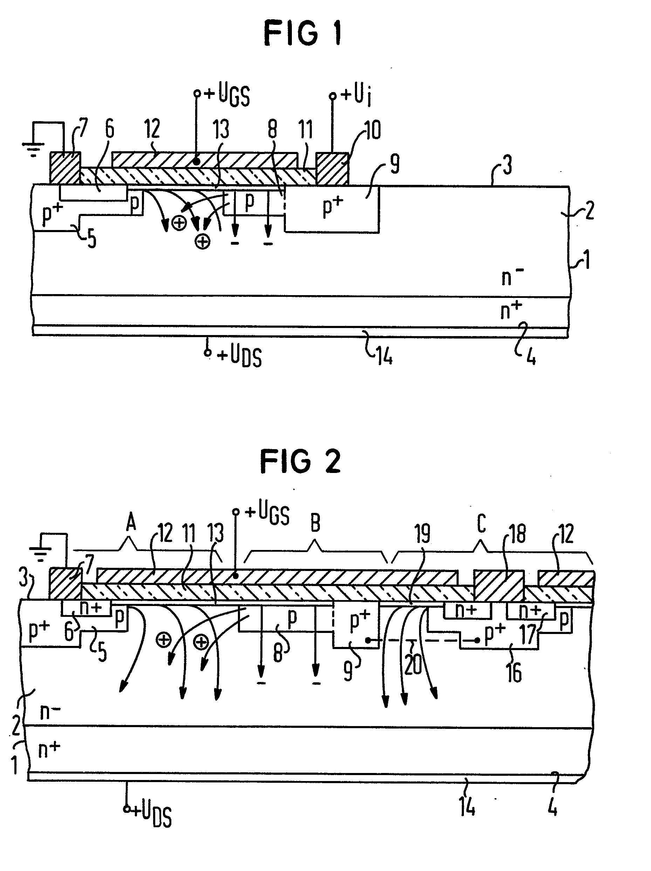

Der IGFET nach Fig. 1 ist auf einem Substrat 1 aufgebaut. Dieses Substrat enthält eine schwach n-dotierte Zone 2, die die Drainzone des IGFET bildet. Die erste Oberfläche des Substrats ist mit 3, die zweite mit 4 bezeichnet. In die erste Oberfläche 3 ist eine Kanalzone 5 von dem Substrat 2 entgegengesetzten Leitungstyp planar eingebettet. In die Kanalzone 5 ist von der Oberfläche her eine Sourcezone 6 vom ersten Leitungstyp ebenfalls planar eingebettet. Sie ist gegenüber dem Substrat stark dotiert. Im lateralen Abstand von der Kanalzone 5 ist von der ersten Oberfläche 3 her eine Injektorzone 8 planar eingebettet. Die Injektorzone 8 ist über eine Kontaktzone 9 kontaktiert, die vom gleichen Leitungstyp wie die Kontaktzone 8, jedoch höher als diese dotiert ist. Die Kontaktzone 9 ist ihrerseits über einen Kontakt 10 kontaktiert.

Die Oberfläche 3 des Substrats 1 ist mit einer Isolierschicht 11 bedeckt, auf der eine Gateelektrode 12 angeordnet ist. Diese Gateelektrode überdeckt einen an die Oberfläche 3 tretenden Teil der Kanalzone 5, einen an die Oberfläche 3 tretenden Teil der Drainzone 2, die Injektorzone 8 und ist mindestens bis über die Grenze zwischen der Injektorzone 8 und der Kontaktzone 9 geführt. Im Ausführungsbeispiel wird die Kontaktzone 9 ein wenig von der Gateelektrode 12 überlappt. Die Sourcezone 6 ist mit einem Kontakt 7 versehen, der zugleich einen Nebenschluß zur Kanalzone 5 bildet. Die andere Oberfläche 4 des Substrats 1 ist mit einer ohmschen Elektrode 14 versehen. Zwischen der Elektrode 14 und der Drainzone 2 liegt zur Verbesserung der Querleitfähigkeit noch eine hochdotierte Zone gleichen Leitfähigkeitstyps wie die Drainzone 2.

Wird an den IGFET eine Spannung $+U_{DS}$ und an die Gateelektrode eine Spannung $+U_{GS}$ angelegt, so bildet sich unter der Gateelektrode an der Oberfläche der Drainzone eine Akkumulationsschicht 13 bestehend aus negativen Ladungsträgern aus. Zugleich bildet sich an der Oberfläche 3 im Bereich der Kanalzone 5 eine aus negativen Ladungsträgern bestehende Inversionsschicht aus, so daß negative Ladungsträger aus der Sourcezone 6 durch den Kanal in die Drainzone 2 fließen können. Mit steigender Spannung $U_{GS}$ dehnt sich die Akkumulationsschicht 13 in Richtung auf die Injektorzone 8 aus. Erreicht die Akkumulationsschicht 13 die Injektorzone 8, so bildet sich mit weiter ansteigender Spannung $+U_{GS}$ an der Oberfläche der Injektorzone 8 eine Inversionsschicht aus, die n-leitenden Charakter hat. Mit Ausbildung der Inversionsschicht über der Injektorzone bildet sich hier daher eine npn-Zonenfolge, d. h. ein Bipolartransistor aus. Dabei bildet die Inversionsschicht 13 den Emitter, die Injektorzone 8 die Basis und die Drainzone 2 den Kollektor des Bipolartransistors. Mit steigender Gatespannung $+U_{GS}$ wird also im Substrat ein Bipolartransistor zugeschaltet, dessen Emittervorspannung durch die Sourcespannung abzüglich der in der Inversionsschicht 13 abfallenden Spannung ist. Die Basisvorspannung ist durch das Potential $+U_i$ der Kontaktzone vorgegeben. Diese ist gegenüber dem Sourcepotential positiv.

Mit steigender Gatespannung $+U_{GS}$ wird der Bipolartransistor stetig aufgesteuert und injiziert außerdem positive Ladungsträger in die Drainzone 2. Der vom Bipolartransistor injizierte Elektronenstrom ist gleich dem von der Spannungsquelle $U_i$ fließenden Strom mal der Stromverstärkung $\beta$ des Bipolartransistors. Der in die Drainzone injizierte Strom von positiven Ladungsträgern ist einer Erhöhung der Dotierung in der Drainzone gleichzusetzen und bewirkt damit eine Verringerung des Durchlaßwiderstands $R_{on}$.

Damit sich an der Oberfläche der Injektorzone 8 bei den in Frage kommenden Gatespannungen auch bei niedriger Spannung $U_i$ eine Inversionsschicht ausbilden kann, ist diese mindestens an der Oberfläche relativ schwach, z. B. so wie die Kanalzone 5 dotiert. Andererseits muß die Dotierung der Kontaktzone 9 so hoch sein, daß diese nicht zur Emission von positiven Ladungsträgern angeregt wird, da nur solche Bereiche Ladungsträger in die Drainzone 2 injizieren sollen, die dem Strompfad, d. h. dem Kanal,

0098497

benachbart sind. Die Injektorzone kann an der Oberfläche z. B. eine Dotierung zwischen $10^{16}$ und $10^{17}$ Atome cm$^{-3}$ aufweisen, während die Kontaktzone an der Oberfläche eine Dotierung zwischen $10^{18}$ und $10^{20}$ haben kann. Damit wird bei einem spezifischen Widerstand von 50 Ohm cm für die Drainzone 2, einer Dicke der Isolierschicht 11 von z. B. 60 nm, einer Gatespannung $U_{GS}$ von z. B. 10 V und einer Spannung $U_i$ von z. B. 1 V eine gute Emissionswirkung und damit ein Absenken des Durchlaßwiderstands $R_{on}$ um mindestens den Faktor 3 erreicht. Die Spannung $+U_i$ muß nicht aus einer gesonderten Spannungsquelle stammen, die Elektrode 10 kann auch direkt oder über einen Widerstand mit der Gatespannungs-Quelle verbunden sein.

Der Bipolartransistor erfordert eine gewisse Steuerleistung, was für viele Zwecke unerwünscht ist. In Fig. 2 ist eine Anordnung gezeigt, bei der die Steuerleistung für den Bipolartransistor aus der Source-Drain-Spannungsquelle stammt. Gleiche oder funktionsgleiche Teile sind dabei mit gleichen Bezugsziffern wie in Fig. 1 versehen. Der IGFET nach Fig. 2 unterscheidet sich von dem nach Fig. 1 dadurch, daß in die Oberfläche 3 des Substrats 1 ein Hilfs-FET (C) integriert ist. Dieser hat eine Kanalzone 16 und eine Sourcezone 17. Beide Zonen sind über einen Kontakt 18 elektrisch miteinander verbunden. Der Hilfs-FET ist mit einer Gateelektrode versehen, die vorzugsweise die für die Steuerung des FET 6, 5, 2, (A) benutzte Gateelektrode sein kann. Sie muß den an die Oberfläche 3 tretenden Teil der Kanalzone 16 vollständig überdecken.

Beim Anlegen einer positiven Gatespannung beginnt der aus den Zonen 6, 5 und 2 bestehende IGFET A und der Hilfs-FET C unter Bildung von Akkumulationszonen 13 und 19 zu leiten. Die Ladungsträger des Hilfs-FET C nehmen dabei ausgehend von der Sourcezone 17 den durch die Pfeile angedeuteten Verlauf zur Drainelektrode 14. Damit stellt sich das Potential der Sourcezone 17 auf ein gegenüber dem Potential der Sourcezone 6 positives Potential ein. Da die Kanalzone 16 mit der Sourcezone 17 über den Kontakt 18 elektrisch verbunden ist, wird auch die Kanalzone 16 gegenüber der Sourcezone 6 positiv vorgespannt. Die Kanalzone 16 ist nun über eine gestrichelt eingezeichnete Verbindung 20 elektrisch mit der Kontaktzone 9 verbunden. Diese Verbindung wird zweckmäßigerweise durch einen in einer anderen als der Zeichenebene liegenden Steg hergestellt, der gleichen Leitungstyp wie die Kanalzone 16 und die Kontaktzone 9 hat. Zweckmäßigerweise ist er auch gleich hoch dotiert. Damit wird die Kontaktzone 9 gegenüber der Sourcezone 6 positiv vorgespannt und die oben beschriebene Wirkung des Bipolartransistors (B) setzt ein, vorausgesetzt daß die Akkumulationsschicht 13 zur Inversion des oberflächennahen Bereichs der Injektorzone 8 geführt hat. Dies ist z. B. bei den in Verbindung mit Fig. 1 genannten Dimensionierungen der Fall.

Damit der aus dem Hilfs-FET C stammende Sourcestrom nicht direkt durch eine Akkumulationsschicht zum Sourcekontakt 7 abfließt, ist die Kontaktzone 9 des Bipolartransistors B so zwischen dem IGFET A und dem Hilfs-FET C angeordnet, daß sich unter der Gateelektrode 12 zwei vollständig elektrisch voneinander getrennte Akkumulationsschichten 13, 19 ausbilden. In diesem Fall liefert daher der Hilfs-FET C den Basisstrom für den Bipolartransistor B.

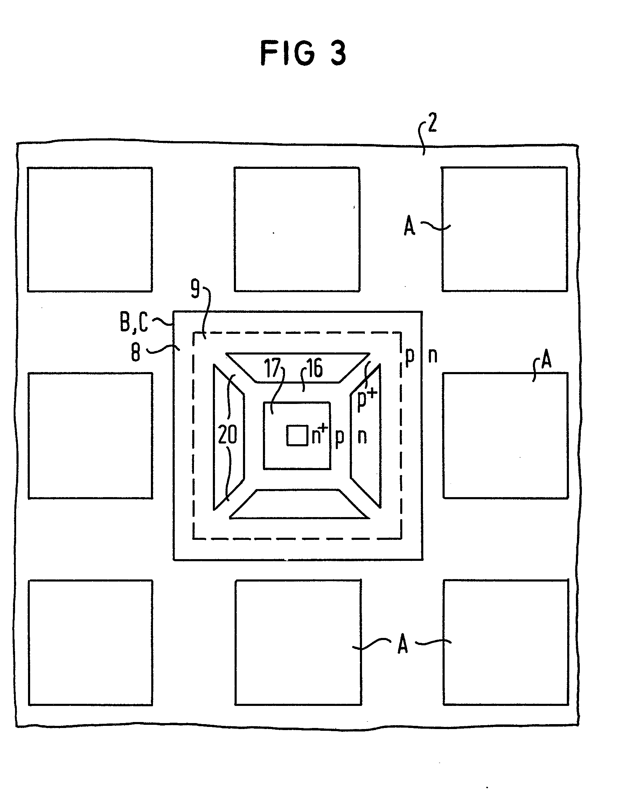

Für höhere Ströme können auf einen Chip mehrere der Strukturen A, B und C rasterartig aufgebaut werden. In Fig. 3 ist eine Aufsicht auf eine solche Anordnung dargestellt, bei der der besseren Übersichtlichkeit halber sämtliche Elektroden und die Isolierschicht 11 weggelassen wurde. Die IGFET A werden hierbei durch eine Metallschicht einander parallelgeschaltet. Die in Verbindung

0098497

mit Fig. 2 erwähnten elektrischen Verbindungen 20 sind hier als diagonal verlaufende, stark p-dotierte Stege dargestellt. Wesentlich ist auch hier die vollständige Unterbrechung der zu den IGFET-Zellen A gehörenden Akkumulationsschicht von den zu den Hilfs-FET-Zellen C gehörenden Akkumulationsschichten. Zu diesem Zweck sind die Kontaktzonen 9 und die Injektorzonen 8 ringförmig ausgebildet und umgeben jeden Hilfs-FET C ringförmig.

3 Figuren
6 Patentansprüche

0098497

## Patentansprüche

1. IGFET mit einem Halbleitersubstrat vom ersten Leitungstyp, mit mindestens einer in die erste Oberfläche (3) des Substrats eingebetteten Kanalzone (5) vom entgegengesetzten Leitungstyp und mit einer in die Kanalzone (5) eingebetteten Sourcezone (6) vom ersten Leitungstyp, mit einer an die erste Oberfläche angrenzenden Drainzone (2), mit einer mit der anderen Oberfläche (4) verbundenen Drainelektrode (14), mit einer in die erste Oberfläche eingebetteten, an eine Spannung anschließbaren Injektorzone (8) vom entgegengesetzten Leitungstyp, und mit einer gegen die erste Oberfläche isolierten Gateelektrode (12), d a d u r c h   g e k e n n z e i c h n e t ,   daß die Injektorzone (8) unter der Gateelektrode (12) liegt, daß die Dotierung der Injektorzone zumindest an der Oberfläche derart bemessen ist, daß sich bei eingeschaltetem IGFET an der Oberfläche der Injektorzone eine Inversionsschicht ausbildet, daß die Injektorzone (8) über eine in die erste Oberfläche eingebettete Kontaktzone (9) vom gleichen Leitungstyp wie die Injektorzone kontaktiert ist, daß die Dotierung der Kontaktzone (9) höher als die der Injektorzone und derart bemessen ist, daß sich bei eingeschaltetem IGFET an der Oberfläche der Kontaktzone keine Inversionsschicht ausbildet, und daß die Gateelektrode (12) über der Grenze Kontaktzone-Injektorzone liegt.

2. IGFET nach Anspruch 1, d a d u r c h   g e k e n n z e i c h n e t ,   daß in der ersten Oberfläche (3) ein Hilfs-FET (C) eingebettet ist, der eine Kanalzone (16) vom entgegengesetzten Leitungstyp, eine Sourcezone (17) vom ersten Leitungstyp und eine Gateelektrode hat, daß Sourcezone und Kanalzone des Hilfs-FET über einen Kontakt (18) elektrisch miteinander verbunden sind, daß die Kanalzone (16) des Hilfs-FET elektrisch mit der Kontaktzone (9) verbunden ist und daß die Gateelektrode (12) des IGFET (A) mit der Gateelektrode des Hilfs-FET (C) elektrisch verbunden ist.

3. IGFET nach Anspruch 2, d a d u r c h   g e k e n n - z e i c h n e t ,  daß die Kanalzone (16) des Hilfs-FET mit der Kontaktzone (9) durch einen in die erste Oberfläche eingebetteten Steg (20) verbunden ist, der gleichen Leitungstyp wie die Kontaktzone und die Kanalzone hat.

4. IGFET nach Anspruch 2, d a d u r c h   g e k e n n - z e i c h n e t ,  daß der IGFET (A) und der Hilfs-FET (C) eine gemeinsame Gateelektrode (12) haben, daß die Kontaktzone (9) unter der Gateelektrode (12) liegt und daß die Kontaktzone derart zwischen dem IGFET und dem Hilfs-FET angeordnet ist, daß eine sich unter der Gateelektrode ausbildende Akkumulationsschicht (13, 19) zwischen den Kanalzonen des IGFET und des Hilfs-FET vollständig unterbrochen ist.

5. IGFET nach Anspruch 3 oder 4, d a d u r c h   g e - k e n n z e i c h n e t ,  daß die Kanalzonen (5, 16) im Substratinneren an der von der ersten Oberfläche abgewandten Seite einen Bereich höherer Dotierung und gleichen Leitungstyps aufweist und daß der Steg (20) mit diesem Bereich verbunden ist.

6. Integrierte Halbleiteranordnung nach einem der Ansprüche 2 bis 5, d a d u r c h   g e k e n n z e i c h - n e t ,  daß im Substrat eine Vielzahl elektrisch parallelgeschalteter IGFET (A) und eine Vielzahl von Hilfs-FET (C) rasterartig angeordnet sind, daß die Injektorzonen (8) und die Kontaktzonen (9) ringförmig ausgebildet sind und je einen Hilfs-FET (C) umschließen.

## FIG 1

## FIG 2

FIG 3

0098497

2/2